# EUROPEAN PATENT APPLICATION

(11) **EP 4 080 593 A1**
(43) Date of publication of application: **26.10.2022**
(21) Application number: 21169832.9
(22) Date of filing: 22.04.2021
(51) Int. Cl.: H01L 45/00, H01L 27/24

(54) **PHASE CHANGE SWITCH DEVICE AND METHOD FOR MANUFACTURING THE SAME**

(71) Applicant: Infineon Technologies AG, 85579 Neubiberg (DE)
(72) Inventor: HEISS, Dominik, 80799 München (DE); BUTSCHKOW, Christian, 81671 München (DE); KADOW, Christoph, 82131 Gauting (DE); TADDIKEN, Hans, 81737 München (DE)
(74) Representative: Sticht, Andreas

(57) **Abstract**

A switch device is disclosed which includes an electrically conducting layer (23) arranged between a phase change switch (26-29) and a substrate (21). The conductive layer has a resistivity of 10⁻⁴ Ω·m or less, and may include a metal layer or a semiconductor layer having a dopant concentration of at least 10¹⁹/cm³.

## Description

### TECHNIAL FIELD

The present application relates to switch devices and methods for manufacturing switch devices.

### BACKGROUND

The technical requirements for radio frequency (RF) applications using high frequencies, such as radar sensing and mobile communication according to the 5G standard, are increasing. In particular, switches having improved characteristics compared to state-of-the-art CMOS switches will be required to meet future demands. Phase change switches are considered as promising candidates for switching RF signals. Such phase change switches use a phase change material (PCM) which typically exhibits a higher electric conductivity in a crystalline phase state than in an amorphous phase state. By changing the phase state of the phase change material, a switching device including such a material may be switched on or off.

For example, to change the phase state from amorphous to crystalline, typically a heater is employed heating the phase change material causing crystallization. This switching on is also referred to as a set operation of the switching device. In this set operation, the heater is actuated in such a way that the temperature of the phase change material is above its crystallization temperature, typically about 250°C, but below the melt temperature of typically in a range of 600°C to 900°C, for example. The length of the heating pulse caused by the heater is chosen such that any amorphous region present in the PCM can regrow into the crystalline phase state.

When switching off the switching device, also referred to as reset operation, the heater is actuated in such a way that the temperature of the PCM is raised above the melt temperature (for example above about 600°C to 900°C), followed by rapid cooldown which freezes the phase change material into an amorphous state.

The above-mentioned rapid cooldown is typically achieved by placing the heater and PCM close to a substrate used, which may be a silicon substrate. Such a silicon substrate has good heat conduction properties and therefore assists the cooldown. However, the close proximity of the phase change switch to the substrate may also cause noise from free carriers or traps in the substrate to influence the behavior of the switch, which may for example lead to a degradation of linearity and generation of higher harmonic signals in radio frequency applications.

An alternative approach for cooling is the use of a layer of dielectric material with high thermal conductivity which is essentially electrically isolating (low electrical conductivity). While materials with such properties are known, for example diamond like carbon, aluminum nitride and the like, thermal restrictions in semiconductor processing usually do not allow deposition of these materials with sufficiently high quality, especially when integrating phase change switches with other passive or active devices on a silicon substrate.

### SUMMARY

A switch device as defined in claim 1 and a method as defined in claim 14 are provided. The dependent claims define further embodiments.

According to an embodiments, a switch device is provided, comprising:
a substrate,
a phase change switch, and
an electrically conducting layer having a resistivity of 10mΩ×cm or less between the substrate and the phase change switch.

According to another embodiment, a method for manufacturing a switch device is provided, comprising:
providing a substrate,
providing an electrically conducting layer above the substrate; and
providing a phase change switch above the electrically conducting layer.

The above summary is merely intended as a brief overview over some features of some embodiments and is not to be construed as limiting in any way, as other embodiments may include different features than the ones explicitly given above.

### BRIEF DESCRIPTION OF THE DRAWINGS

Fig. 1 is a schematic cross-sectional view of a switch device according to an embodiment.
Figs. 2A to 2D are cross-sectional views of switch devices according to some embodiments.
Figs. 3A and 3B are cross-sectional views of switch devices according to some embodiments.
Fig. 4 is a cross-sectional view of a switch device according to some embodiments, perpendicular to the cross-sectional view of Fig. 2A.
Fig. 5A is a cross-sectional view of a switch device according to an embodiment, and Figs. 5B to 5D are plan views of electrically conducting layers of switch devices according to some embodiments.
Fig. 6 is a schematic cross-sectional view of a switch device according to an embodiment.
Figs. 7A to 7D are cross-sectional views illustrating a switch device and its manufacturing involving wafer bonding.
Fig. 8 is flowchart illustrating a method according to an embodiment.

### DETAILED DESCRIPTION

In the following, various embodiments will be described in detail referring to the attached drawings. The embodiments described hereinafter are to be taken as examples only and are not to be construed as limiting. For example, while in embodiments specific arrangements or components are provided, in other embodiments other configurations may be used.

Besides features (or for example components, elements, acts, events or the like) explicitly shown and described, in other embodiments additional features may be provided, for example features used in conventional switch devices using phase change materials. For example, embodiments described herein relate to providing an electrically conducting layer between a phase change switch and a substrate, and other components and features, like control circuitry for controlling a heater, radio frequency (RF) circuitry using the switch device and the like may be implemented in a conventional manner. Such additional components may be integrated with the described switch devices on the same substrate, but may also be provided separately for example, on one or more separate chip dies, which in some implementations then may be combined with a switch device in a common package. Also, manufacturing implementations like providing phase change material on a substrate like a silicon substrate to implement a phase change switch, providing phase change material in a trench in a silicon substrate for manufacturing the switch device and the like may be performed in any conventional manner.

A switch based on a phase change material (PCM) will be referred to as a phase change switch or short PCM switch herein. As explained in the introductory portion, such phase change switches may be set to a crystalline phase state or an amorphous phase change, thus changing the resistance of the phase change material and therefore of the switch by several orders of magnitude. In this way, for example an onresistance of a switch in a range of 1 to 100 Ω may be achieved, whereas an off-resistance may be several orders of magnitude higher, for example at least in the kilo ohm range.

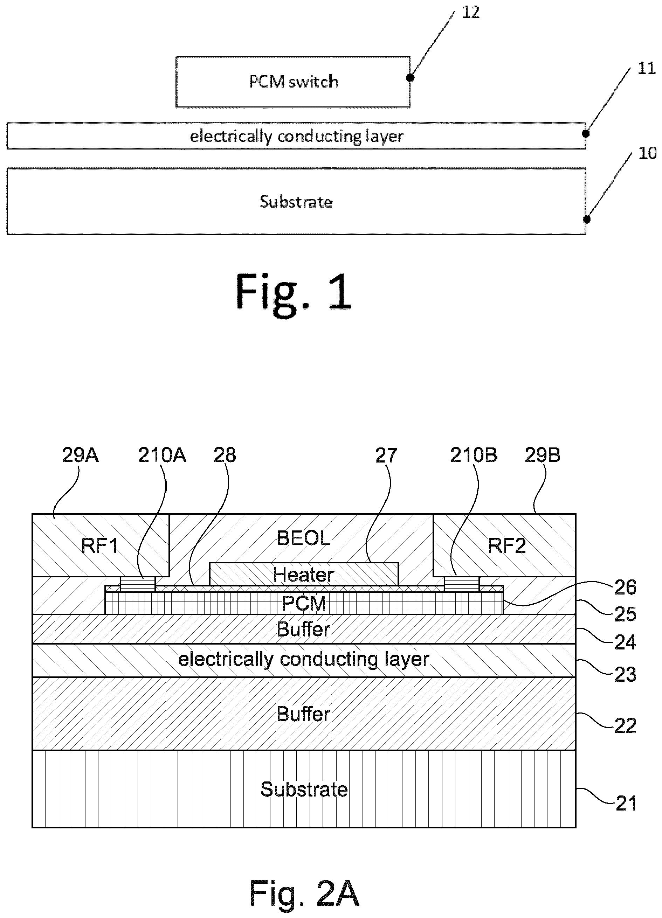

Implementation details described with respect to one of the embodiments are also applicable to other embodiments. For example, with respect to Fig. 1, possible materials are described, and these may also be used in other embodiments described herein and will therefore not be described repeatedly. Moreover, to avoid repetitions, corresponding elements bear the same reference numerals in different drawings and will not be described in detail repetitively.

Turning now to the figures, Fig. 1 illustrates a switch device according to an embodiment.

The switch device of Fig. 1 is provided on a substrate 10. In embodiments, substrate 10 may be an undoped silicon substrate or other semiconductor substrate, but is not limited thereto. For example, in other embodiments, substrate 10 may for example be a glass substrate or a doped silicon substrate.

Above substrate 10, an electrically conducting layer 11 is provided. "Above substrate 10" indicates that the electrically conducting layer may be provided directly on substrate 10, but, as will be explained in more detail further below, also intervening layers may be provided between electrically conducting layer 11 and substrate 10, for example a dielectric buffer layer. Electrically conducting layer 11, as used herein, refers to a layer having a high electric conductivity corresponding to low electric resistivity, for example a resistivity of 10mΩ×cm or less. For example, to achieve such an electrical conductivity, a semiconductor material like polycrystalline silicon with a dopant concentration of at least 10¹⁹/cm³ may be used. In other embodiments metals, for example copper or tungsten may be used for the electrically conducting layer. Such metals typically have resistivities about 3 orders of magnitude lower than the 10mΩ×cm mentioned above. Furthermore, as will be explained below, electrically conducting layer 11 may be a continuous layer, but also may be a patterned layer, discontinuous layer, include several sub-layers, be a layer with varying thickness, etc.

Above electrically conducting layer 11, a phase change switch (PCM switch) 12 is provided. PCM switch 12 usually includes a heater and a phase change material and may be operated as described above. A suitable phase change material is for example germanium telluride. The heater may be made of a material like polycrystalline silicon or tungsten. The heater is then controlled by a controller (not shown in Fig 1) in a conventional manner to change the state of the phase change material. In some embodiments, the phase change switch may be used to switch radio frequency (RF) signals. Radio frequency, in this respect, refers to signals having a frequency of at least 1 MHz, for example above 100 MHz, for example in the gigahertz (GHz) range. For example, phase change switch 12 may be used in antenna tuning applications to selectively couple tuning elements like capacitors or inductors to an antenna.

Electrically conducting layer 11 in embodiments serves two functions: on the one hand, it serves to transport heat away from PCM switch 12, to enable a rapid cooling after heating. In some embodiments, heat may be transported away from PCM switch 12 to the sides of the arrangements shown in Fig 1. For example, heat may be conducted laterally towards bond pads or the like. In other embodiments, additionally or alternatively, heat may be transported from PCM switch 12 to substrate 10 via electrically conducting layer 11. In this sense, electrically conducting layer 11 may be referred to as a heat pipe. It should be noted that electrically conducting materials like metals or highly doped semiconductors generally also exhibit a high heat conductivity and thus may serve to transport heat effectively.

As second function, and unlike conventional solutions using dielectric heat conducting layers, electrically conducting layer 11 serves as a radio frequency shielding, shielding PCM switch 12 from substrate 10 and possible from further layers between electrically conducting layer 11 and substrate 10. This radio frequency shielding may contribute to increasing a linearity of the switch device of Fig. 1, as for example an influence of free carriers or traps in substrate 10 on the behavior of PCM switch 12 is at least significantly reduced, if not suppressed entirely. This may lead to relaxed requirements regarding substrate 10. For example, while in conventional approaches silicon substrates or other semiconductor substrates with as low doping as possible may be used to reduce free carriers, in embodiments also higher doped semiconductor substrates, which may be cheaper, or other kinds of substrate like glass substrates may be used. Moreover, in some implementations, active or passive elements may be provided on substrate 10 between substrate 10 and electrically conducting layer 11, without greatly affecting the behavior of PCM switch 12. In other words, substrate properties like free carriers, noise, resistivity and thermal conductivity have no or little relevance with the electrically conducting layer 11 being provided.

Electrically conducting layer 11 may be provided essentially in a standard back end of line (BEOL) semiconductor process and is therefore comparatively easy to manufacture with standard semiconductor technology. The electrically conducting layer 11 may also block light, in particular infrared light, generated by a heater of phase change switch 12. Such light otherwise could be absorbed by substrate 10, which may lead to noise or nonlinearities for PCM switch 12 or other devices manufactured on substrate 10.

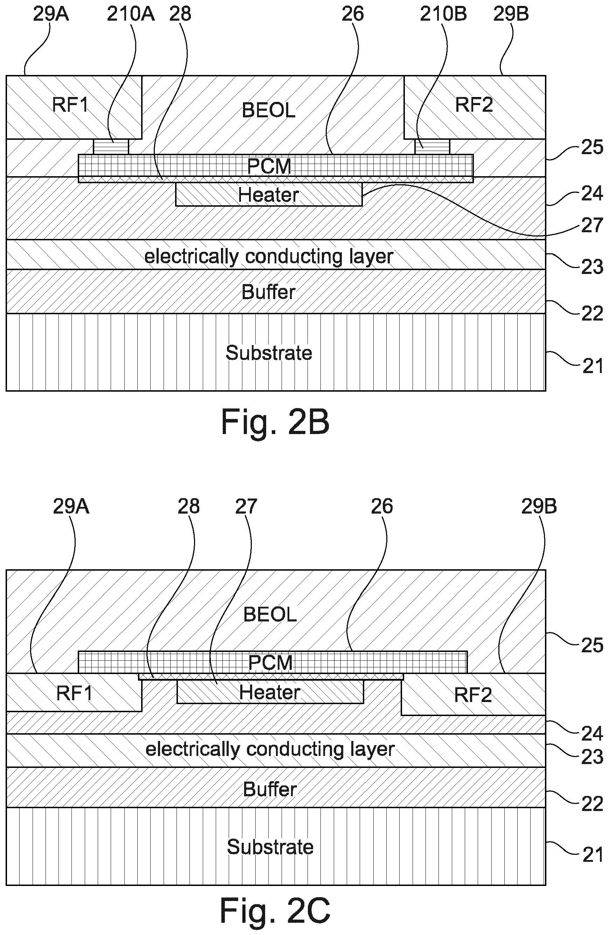

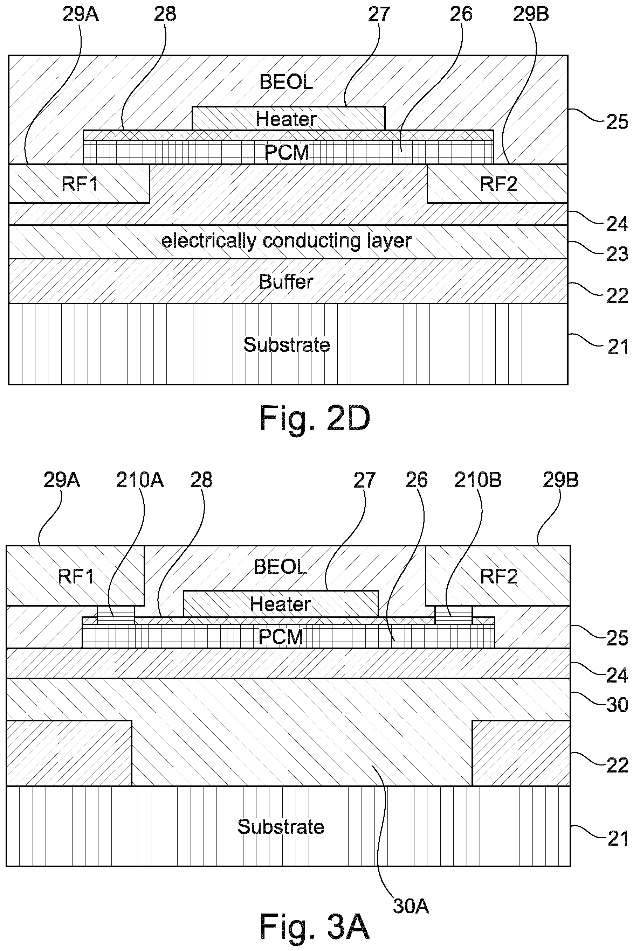

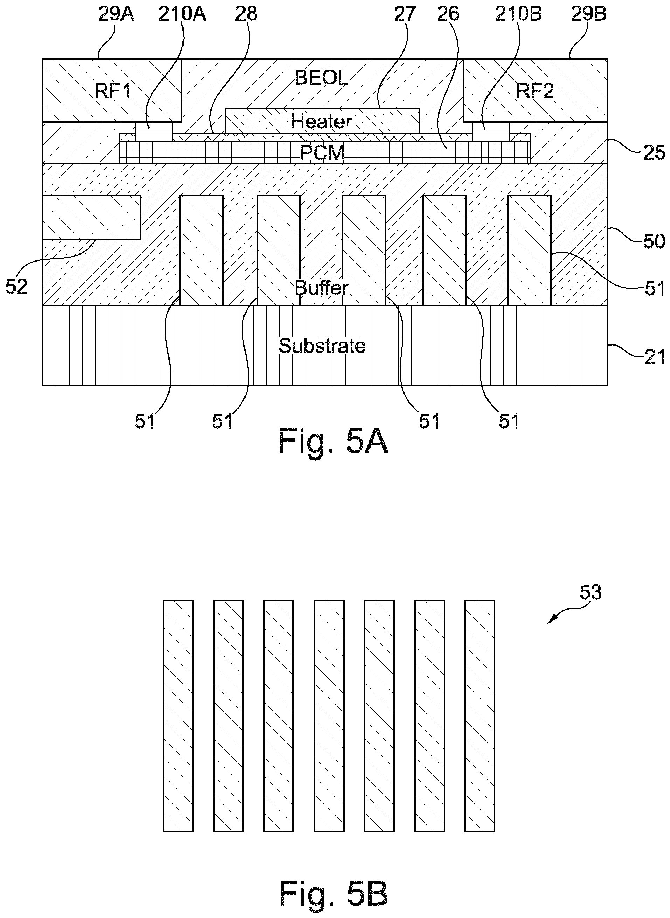

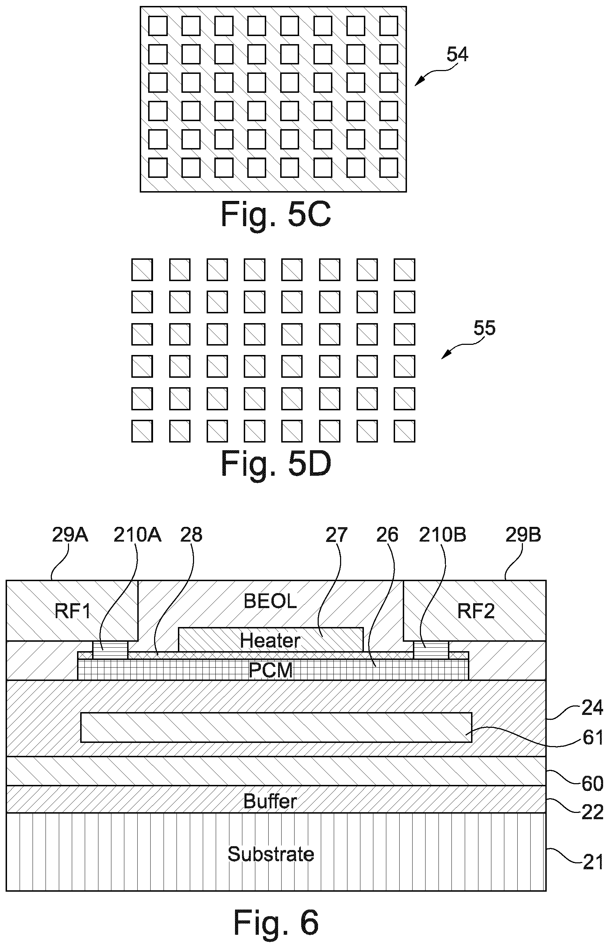

Fig. 1 shows a basic configuration of some embodiments. Within this basic configuration, many variations are possible, as will now be explained with reference to Figs. 5 to 7. The explanations for Fig. 1, however, are also applicable to Figs. 2 to 7 and will therefore not be repeated for every figure.

Figs. 2A to 2D show cross-sectional views of switch devices according to some embodiments. The embodiments of Figs. 2B to 2D are variations of the embodiment of Fig. 2A. In the following, first the embodiment of Fig. 2A will be described, and then the differences of the embodiments of Figs. 2B to 2D with respect to Fig. 2A will be described, without repeating the description for the parts which remain the same.

The switch device of Fig. 2A is provided on a substrate 21, which may correspond to substrate 10 of Fig. 1 and to which the same considerations apply. On substrate 21, a dielectric buffer layer 22 is provided, for example made of silicon oxide, silicon nitride or any other dielectric conventionally used in semiconductor device processing. In other embodiments, buffer layer 22 may be omitted.

On buffer layer 22, an electrically conducting layer 23 is provided, which may correspond to electrically conducting layer 11 of Fig. 1, and the corresponding explanations apply also to electrically conducting layer 23 of Fig. 2A.

On electrically conducting layer 23, a further buffer layer 24, for example made of a dielectric material, is provided. Buffer layer 24 provides a non-electrically conductive barrier between electrically conducting layer 23 and the actual PCM switch. The PCM switch includes a phase change material 26 provided on buffer layer 24 and a heater 27 provided on phase change material 26. Heater 27 and phase change material 26 are separated by a barrier layer 28, for example a dielectric layer.

Contact elements 29A and 29B for coupling for example to a radio frequency (RF) device to receive/transmit/switch signals RF1, RF2 are provided, which are electrically coupled to phase change material 26 via vertical interconnects (VIAs) 210A, 210B, respectively. Contact elements 29A, 29B may for example include leads, strip lines, RF wiring or signal lines. Contact elements 29A, 29B as well as vertical interconnects 210A, 210B may be formed in a conventional back end of line (BEOL) process, within one or more BEOL dielectric layers 25. Heater 27 may be contacted by further contact elements (not shown), which for example may be arranged on both sides of the cross-section shown in Fig. 2B in a direction perpendicular to the cross-section shown.

As will now be explained referring to Figs. 2B to 2D, there are other possibilities of arranging heater 27, phase change material 26 and contact elements 29A, 29B than the one shown in Fig. 2A.

In Fig. 2B, the arrangement of phase change material 26 and heater 27 is exchanged compared to Fig. 2A, i.e. the heater is provided between phase change material 26 and electrically conducting layer 23 as shown in Fig. 2B, whereas in Fig. 2A phase change material 26 is arranged between heater 27 and electrically conducting layer 23. Apart from that, the embodiment of Fig. 2B corresponds to the embodiment of Fig. 2A.

In Fig. 2C, contact elements 29A, 29B are arranged in buffer layer 24 to contact phase change material 26 from "below", i.e. on a side of phase change material 26 facing substrate 21, whereas in Figs. 2A and 2B, contact elements 29A, 29B contact phase change material 26 on a side of phase change material 26 facing away from substrate 21, i.e. from "above". In this respect, terms like "above" and "below" are to be understood as relative to the substrate (i.e. the substrate is at the "bottom" of the arrangement) for easy explanation, but is not to be construed as implying any necessary orientation of the complete device in space. For example, in a radio frequency device, the switch devices shown may be incorporated in any orientation desired for a particular application.

The embodiments of Figs. 2A to 2C offer different advantages and may be selected depending on implementations. For example, in the embodiment of Fig. 2A, the heat flow from heater 27 to electrically conducting layer 23 is through phase change material 26, which may allow for a more efficient heating in some embodiments. In the embodiment of Fig. 2B, as heater 27 is on a different side of phase change material 26 than contact elements 29A, 29B, a capacitive coupling between heater 27 and the radio frequency signals RF1, RF2 may be reduced.

The embodiment of Fig. 2C may offer advantages in terms of manufacturing complexity in standard semiconductor manufacturing processes.

Fig. 2D shows a cross-section of a further embodiment, which essentially has the arrangement of heater and PCM as in Fig. 2A (phase change material 26 between heater 27 and substrate 21) and the contacting of phase change material 26 by contact elements 29A, 29B from "below" as in Fig. 2C.

Here, in terms of manufacturing complexity, the provision of contact elements 29A, 29B below phase change material 26 may ease manufacturing complexity as in Fig. 2C, and the arrangement of phase change material 26 between heater 27 and electrically conducting layer 23 may increase heating efficiency in some implementations.

For the embodiments discussed next, referring to Figs. 3A to 6, the arrangement of heater 27, phase change material 26 and contact elements 29A, 29B as in Fig. 2A is used. For each of these embodiments, instead also the configuration shown in Figs. 2B, 2C or 2D may be equally used. Furthermore, these embodiments are variations of the embodiment of Fig. 2A, and again like elements bear the same reference numerals and will not be described again in detail. Instead, only the variations to the embodiment of Fig. 2A will be described.

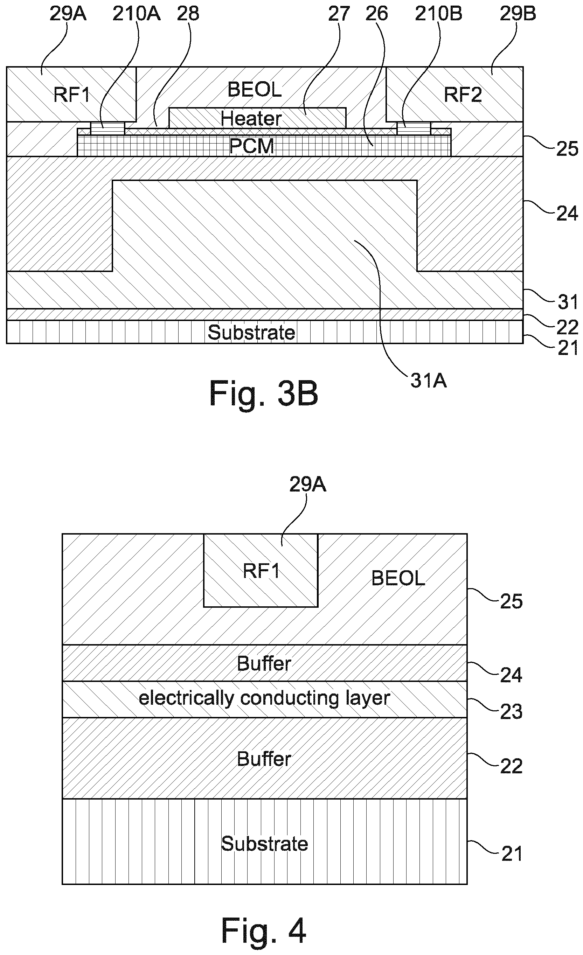

In the embodiments of Figs. 3A and 3B, the electrically conducting layer is designed to provide a heat transfer to substrate 21. In the embodiment of Fig. 3A, the electrically conducting layer includes a continuous portion 30 and a thickened portion 30A extending below phase change material 26 to substrate 21 as shown. Thickened portion 30A may be contact substrate 21 or may be separated from substrate 21 by a thin portion of buffer 22. In this way, in some implementations, heat may be transported to substrate 21 more efficiently by facilitating a vertical heat transfer towards substrate 21 through electrically conducting layer 30, 30A.

The embodiment of Fig. 3B shows a similar arrangement. However, here, a continuous portion 31 is arranged close to substrate 21 (separated from substrate 21 through buffer 22 in Fig. 3B, but may also contact substrate 21 directly), with a thickened portion 31A being provided extending from continuous portion 31 towards phase change material 26. Also here, a vertical heat transfer from phase change material 26 to substrate 21 may be facilitated.

Otherwise, the embodiments of Figs. 3A and 3B correspond to the embodiment of Fig. 2A.

The electrically conducting layer together with the contact terminals 29A, 29B may essentially form a microstripline design. This is illustrated in Fig. 4, which shows a cross-sectional view of an embodiment through contact element 29A in a direction perpendicular to the view of Fig. 2A. A microstripline for conducting radio frequency signals is then essentially formed by coupling electrically conducting layer 23 to ground. This microstripline may be designed to have a defined impedance, for example to provide a 50 Ω impedance wiring.

In Figs. 2 to 4, the electrically conducting layer is shown as a continuous layer. In other embodiments, patterned layers may be used. This will be explained with reference to Figs. 5A to 5D.

Fig. 5A is a cross-section of a switch device according to a further embodiment. Here, the electrically conducting layer consists of vertical columns 51 and a horizontal portion 52. Vertical columns 51, similar to portions 30A, 31A of Figs. 3A and 3B, may facilitate vertical heat transfer towards substrate 21. Other patterned electrically conductive layers are also possible. Examples are shown in Figs. 5B to 5D, each showing a plan view of an example electrically conducting layer. For example, Fig. 5B shows an electrically conducting layer 53 having a slotted pattern, Figs. 5C shows an electrically conducting layer 54 having holes, and Fig. 5D shows an electrically conducting layer 55 having pillars or columns. The pattern may be selected based on various criteria like overall impedance, thermal properties (heat conduction) or electrical properties. Furthermore, additionally or alternatively, the pattern may be made based on processing requirements. For example, for metal layer often a certain filling is desirable, i.e. a certain amount to which metal is present in a particular metal layer in processing, or may involve so-called "cheesing", which correspond to small rectangular cut outs in a continuous metal layer. Such process requirements may be taken into account in the pattern used for the electrically conducting layer.

Furthermore, in some embodiments, the electrically conducting layer may include several sub-layers, which may be patterned or unpatterned. An example is shown in Fig. 6, which shows a cross-section of a switch device according to a further embodiment. In the embodiment of Fig. 6, the electrically conducting layer includes a first sub-layer 60, which is essentially continuous, and a second sub-layer 61, which is provided essentially below phase change material 26. Each sub-layer 60 or 61 may be patterned. Also, more than two sub-layers may be provided. The number and possible patterning of sub-layers may also be selected based on the criteria mentioned above, i.e. thermal properties, electrical shielding and process requirements.

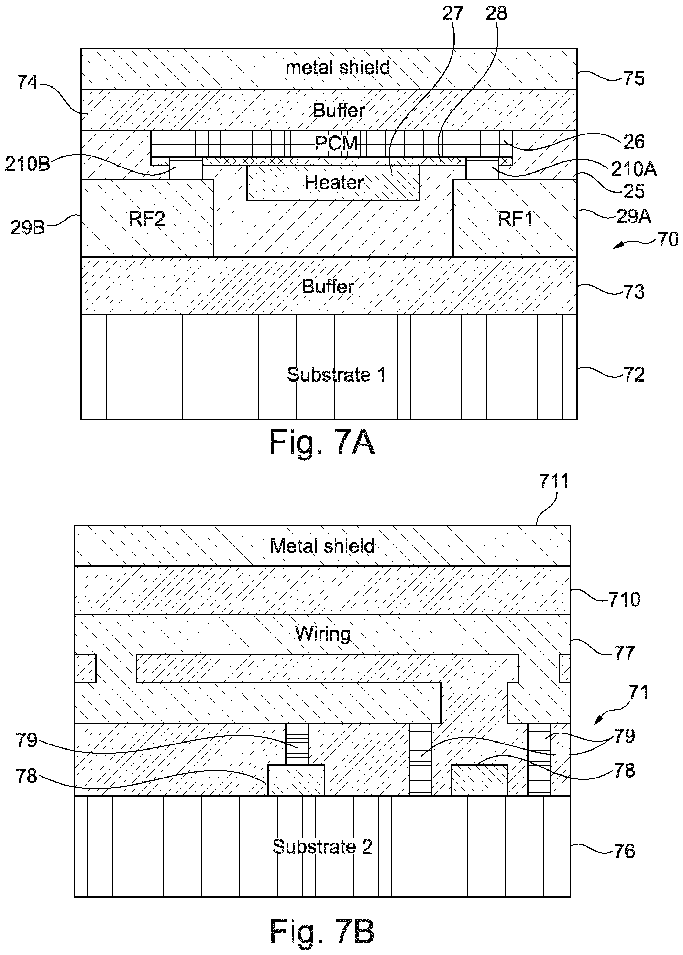

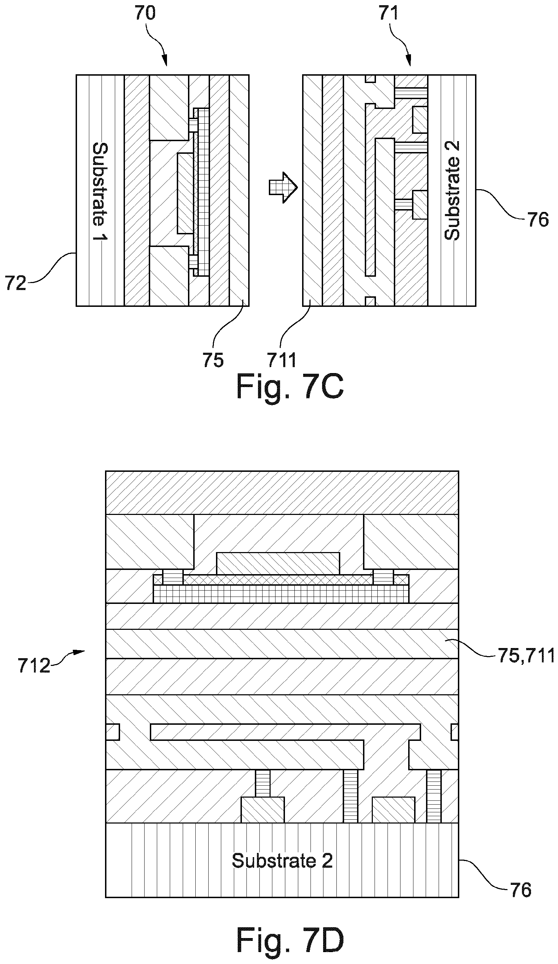

In some embodiments, a switch device may be provided by manufacturing parts thereof and on two different substrates and then bonding the two parts. The electrically conducting layer may be used for bonding, in particular in case of a metal layer. An example is shown in Fig. 7, including subfigures 7A to 7D.

Fig. 7A shows a first part of a device including a PCM switch. The first part 70 is provided on a substrate 72. As substrate 72 will be ultimately removed, any kind of substrate may be used. On substrate 72, a buffer 73 is provided, for example, based on a dielectric material. On buffer 73, the PCM switch arrangement already discussed including phase change material 26, heater 27, layer 28, contact elements 29A, 29B, vertical interconnects 210A, 210B within a BEOL layer(s) 25 are provided. On top of this structure, a further buffer layer 74 followed by a metal shield layer 75 is provided.

A second device part 71 is illustrated in Fig. 7B. Second device part 71 is provided on a second substrate 76. Second substrate 76 may for example be a silicon substrate on which devices 78 are formed using standard CMOS processes. Devices 28 may extend into substrate 76 and may for example include transistors, diodes and MOS capacitors. Other devices and other substrates for forming semiconductor devices may also be used. Devices 78 are then contacted using back end of line processing by forming for example vertical interconnects 79 and a wiring 77 within dielectric material 710. On top of dielectric material 710, a metal shield layer 711 is provided. Apart from the provision of metal shield layer 711, second part 71 may be a device provided by any standard device manufacturing process. Devices 79 may be active devices, passive devices or mixture of both kinds of devices.

First part 70 and second part 71 are then bonded together at their respective metal layers 75, 711 as shown in Fig. 7C. Bonding methods like ZIBoND, DBI bond or hybrid bonding may be used. Metal layers 75, 711 may cover at least the PCM switch device, with overhang on the sides, but may be discontinuous in some embodiments on chip level e.g. to allow for electrical connections.

Then, at least substrate 72 is removed to arrive at device 712 shown in Fig. 7D. Electrically conducting layer 75, 711 resulting from the bonding of metal shields layers 75 and 711 shields the PCM switch from wiring 77 and devices 78 and therefore enables integration of the device together with a PCM switch.

The resulting arrangement of heater and PCM material and contact elements 29A, 29B is similar to Fig. 2A, whereas for manufacturing (see Fig. 7A) it is similar to Fig. 2C. Other configurations shown in Figs. 2A to 2D may also be employed.

Furthermore, the metal shields 75, 711 may be patterned as explained with reference to Fig. 5, or may include thickened portions or several layers as explained with reference to Figs. 3 and 6, respectively.

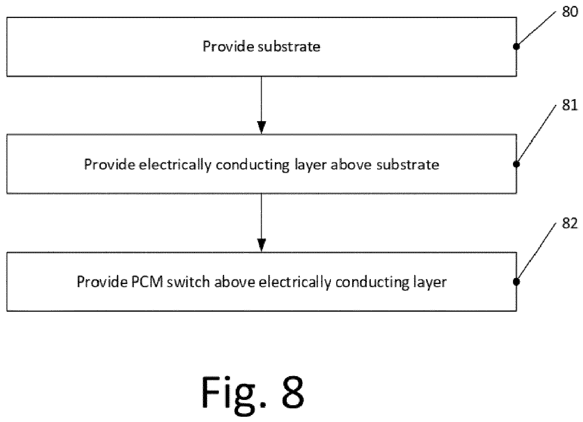

Fig. 8 is a flowchart illustrating a method for manufacturing a switch device according to an embodiment. The method of Fig. 8 may be used to manufacture any of the switch devices discussed with reference to Figs. 1 to 7 and will be explained referring to these switch devices, but may also be used to manufacture other switch devices.

At 80, the method includes providing a substrate, for example, substrate 10, substrate 21 or substrate 76 discussed previously.

At 81, the method comprises providing an electrically conducting layer on the substrate, for example any of the electrically conducting layers discussed previously.

At 82, the method comprises providing a PCM switch on the electrically conducting layer, as discussed previously. It should be noted that the acts at 81 and 82 may be performed by depositing on the substrate provided at 80, or, for example to manufacture switch device 712 in Fig. 7D, may involve wafer bonding, where the electrically conducting layer and the PCM switch are provided first on a further substrate and then bonded to the substrate provided at 80. Furthermore, as also explained, intermediate layers like buffer layers may be provided, and additional elements like contact elements, wiring, further devices (see Fig. 7) etc. may be additionally provided.

Some embodiments are defined by the following examples:
Example 1. A switch device, comprising:
   a substrate ,
   a phase change switch , and
   an electrically conducting layer having a resistivity of 10mΩ×cm or less between the substrate and the phase change switch.
Example 2. The switch device of example 1, wherein the phase change switch includes a phase change material and a heater.
Example 3. The switch device of example 2, wherein the phase change material is spatially arranged between the heater and the electrically conducting layer.
Example 4. The switch device of example 2, wherein the heater is spatially arranged between the phase change material and the electrically conducting layer.
Example 5. The switch device of any of examples 2 to 4, further comprising contact elements for electrically contacting the phase change material.
Example 6. The switch device of example 5, wherein the contact elements are spatially arranged at a side of the phase change material facing the substrate.
Example 7. The switch device of example 5, wherein the contact elements are spatially arranged at a side of the phase change material facing away from the substrate.
Example 8. The switch device of any of examples 5 to 7, wherein the contact elements and the electrically conducting layer form a microstripline.
Example 9. The switch device of any of examples 1 to 8, wherein the electrically conducting layer comprises a metal layer.
Example 10. The switch device of any of examples 1 to 9, wherein the electrically conducting layer includes a semiconductor layer having a dopant concentration of at least 10¹⁹/cm³.
Example 11. The switch device of any of examples 1 to 10, wherein the electrically conducting layer comprises a continuous layer.
Example 12. The switch device of any of examples 1 to 11, wherein the electrically conducting layer comprises a patterned layer.
Example 13. The switch device of example 12, wherein the patterned layer comprises one or more of slots, columns or holes.
Example 14. The switch device of any of examples 1 to 13, wherein the electrically conducting layer includes a thickened portion in an area between the phase change switch and the substrate.
Example 15. The switch device of any of examples 1 to 14, comprising semiconductor devices between the electrically conducting layer and the substrate and/or extending into the substrate.
Example 16. A method for manufacturing a switch device, comprising:
   providing a substrate ,
   providing an electrically conducting layer having a resistivity of 10mΩ×cm or less above the substrate ; and
   providing a phase change switch above the electrically conducting layer.
Example 17. The method of example 16, wherein providing the electrically conducting layer above the substrate and providing the phase change switch above the electrically conducting layer comprises:
   providing the phase change switch above a further substrate ,
   providing a first electrically conducting layer on the substrate ,
   providing a second electrically conducting layer above the phase change switch provided above the further substrate , and
   bonding the first electrically conducting layer to the second electrically conducting layer to form the electrically conducting layer.
Example 18. The method of example 16 or 17, wherein the method is configured for manufacturing the switch device of any one examples 1 to 15.
Example 19. The method of any of examples 16 to 18, further comprising patterning the electrically conducting layer.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A switch device (712), comprising:
a substrate (10; 21; 76),
a phase change switch (12; 26, 27, 28), and
an electrically conducting layer (11; 23; 30, 30A, 31, 31A; 51, 52, 53, 54, 55; 60, 61; 75, 711) having a resistivity of 10mΩ×cm or less between the substrate (10; 21; 76) and the phase change switch.

2. The switch device (712) of claim 1, wherein the phase change switch (12; 26, 27, 28) includes a phase change material (26) and a heater (27).

3. The switch device of (712) claim 2, wherein the phase change material (26) is spatially arranged between the heater (27) and the electrically conducting layer (11; 23; 30, 30A, 31, 31A; 51, 52, 53, 54, 55; 60, 61; 75, 711).

4. The switch device (712) of claim 2, wherein the heater is spatially arranged between the phase change material (26) and the electrically conducting layer (11; 23; 30, 30A, 31, 31A; 51, 52, 53, 54, 55; 60, 61; 75, 711).

5. The switch device (712) of any of claims 2 to 4, further comprising contact elements (29A, 29B) for electrically contacting the phase change material (26).

6. The switch device (712) of claim 5, wherein the contact elements (29A, 29B) are spatially arranged at a side of the phase change material (26) facing the substrate (10; 21; 76).

7. The switch device (712) of claim 5, wherein the contact elements (29A, 29B) are spatially arranged at a side of the phase change material (26) facing away from the substrate (10; 21; 76).

8. The switch device (712) of any of claims 5 to 7, wherein the contact elements (29A, 29B) and the electrically conducting layer (11; 23; 30, 30A, 31, 31A; 51, 52, 53, 54, 55; 60, 61; 75, 711) form a microstripline.

9. The switch device (712) of any of claims 1 to 8, wherein the electrically conducting layer (11; 23; 30, 30A, 31, 31A; 51, 52, 53, 54, 55; 60, 61; 75, 711) comprises a metal layer.

10. The switch device (712) of any of claims 1 to 9, wherein the electrically conducting layer (11; 23; 30, 30A, 31, 31A; 51, 52, 53, 54, 55; 60, 61; 75, 711) includes a semiconductor layer having a dopant concentration of at least 10¹⁹/cm³.

11. The switch device (712) of any of claims 1 to 10, wherein the electrically conducting layer (11; 23; 30, 30A, 31, 31A; 51, 52, 53, 54, 55; 60, 61; 75, 711) comprises one of a continuous layer or a patterned layer.

12. The switch device (712) of any of claims 1 to 11, wherein the electrically conducting layer (11; 23; 30, 30A, 31, 31A; 51, 52, 53, 54, 55; 60, 61; 75, 711) includes a thickened portion (30A, 31A) in an area between the phase change switch (12; 26, 27, 28) and the substrate (10; 21; 76) .

13. The switch device (712) of any of claims 1 to 12, comprising semiconductor devices (78) between the electrically conducting layer (11; 23; 30, 30A, 31, 31A; 51, 52, 53, 54, 55; 60, 61; 75, 711) and the substrate (10; 21; 76) and/or extending into the substrate (10; 21; 76).

14. A method for manufacturing a switch device, comprising:
providing (80) a substrate (10; 21; 76),
providing (81) an electrically conducting layer (11; 23; 30, 30A, 31, 31A; 51, 52, 53, 54, 55; 60, 61; 75, 711) having a resistivity of 10mΩ×cm or less above the substrate (10; 21; 76); and
providing (82) a phase change switch (12; 26, 27, 28) above the electrically conducting layer (11; 23; 30, 30A, 31, 31A; 51, 52, 53, 54, 55; 60, 61; 75, 711).

15. The method of claim 14, wherein providing the electrically conducting layer (11; 23; 30, 30A, 31, 31A; 51, 52, 53, 54, 55; 60, 61; 75, 711) above the substrate (10; 21; 76) and providing the phase change switch (12; 26, 27, 28) above the electrically conducting layer (11; 23; 30, 30A, 31, 31A; 51, 52, 53, 54, 55; 60, 61; 75, 711) comprises:
providing the phase change switch (12; 26, 27, 28) above a further substrate (10; 21; 76),
providing a first electrically conducting layer (11; 23; 30, 30A, 31, 31A; 51, 52, 53, 54, 55; 60, 61; 75, 711) on the substrate (10; 21; 76),
providing a second electrically conducting layer (11; 23; 30, 30A, 31, 31A; 51, 52, 53, 54, 55; 60, 61; 75, 711) above the phase change switch (12; 26, 27, 28) provided above the further substrate (10; 21; 76), and
bonding the first electrically conducting layer (11; 23; 30, 30A, 31, 31A; 51, 52, 53, 54, 55; 60, 61; 75, 711) to the second electrically conducting layer (11; 23; 30, 30A, 31, 31A; 51, 52, 53, 54, 55; 60, 61; 75, 711) to form the electrically conducting layer.
